# EUROPEAN PATENT APPLICATION

(11) **EP 2 473 016 A1**
(43) Date of publication of application: **04.07.2012**
(21) Application number: 11193684.5
(22) Date of filing: 15.12.2011
(51) Int. Cl.: H05K 3/30, H05K 3/34

(54) **System and method of forming a mechanical support for an electronic component attached to a circuit board**

(30) Priority: 30.12.2010 US 981865
(71) Applicant: Delphi Technologies, Inc., Troy, MI 48007 (US)
(72) Inventor: Sozansky, Wayne A., Greentown, IN Indiana 46936 (US); Yeh, Shing, Kokomo, IN Indiana 46902 (US)
(74) Representative: Denton, Michael John

(57) **Abstract**

A system (10) and method (300) for supporting an electronic component (12) attached to a circuit board (14). solder paste (40) is applied to a solder pad (16) underneath and aligned with a non-wetting region (18) of an electronic component (12) to form a support (34) formed of solder to prevent electronic component (12) lead (26) flexing. The amount of solder for forming the support (34) and the size of the solder pad (16) are selected to bring the support (34) into contact with, or in close proximity to, the non-wetting region (18).

## Description

### TECHNICAL FIELD OF INVENTION

The invention generally relates to mechanically supporting an electronic component attached to a circuit board, and more particularly relates to a system and method of forming a support using solder that is proximate to, or contacting, a non-wetting region of the electronic component.

### BACKGROUND OF INVENTION

It is known to bring a heat sink into contact with an electronic component to help dissipate heat generated by the electronic component. It has been observed that heat dissipation efficiency can be increased by pressing or forcing the heat sink and body of electronic component together. However, it has been observed that the force may fatigue solder joints used to attach the electronic device to the circuit board, particularly solder joints formed on electrical connection leads extending from a plastic encapsulated electronic device such as a quad-flat-pack (QFP) type package.

### SUMMARY OF THE INVENTION

In accordance with one embodiment of this invention, a system for supporting an electronic component attached to a circuit board is provided. The system includes a solder pad and a support. The solder pad is on the circuit board aligned with a non-wetting region of the electronic component. The support is formed of solder overlying the solder pad and proximate to the non-wetting region.

In another embodiment of the present invention, a method of providing support for an electronic component attached to a circuit board is provided. The method includes the step of providing a solder pad on the circuit board aligned with a non-wetting region of the electronic component. The method also includes the step of forming a support of solder overlying the solder pad and proximate to the non-wetting region.

Further features and advantages of the invention will appear more clearly on a reading of the following detailed description of the preferred embodiment of the invention, which is given by way of non-limiting example only and with reference to the accompanying drawings.

### BRIEF DESCRIPTION OF DRAWINGS

The present invention will now be described, by way of example with reference to the accompanying drawings, in which:

Fig. 1 is side view of a circuit board assembly in accordance with one embodiment;

Fig. 2 is series of side views showing the process of assembling the circuit board assembly of Fig. 1 in accordance with one embodiment; and

Fig. 3 is flow chart of a method for forming the circuit board assembly of Fig. 1 in accordance with one embodiment.

### DESCRIPTION OF THE PREFERRED EMBODIMENTS

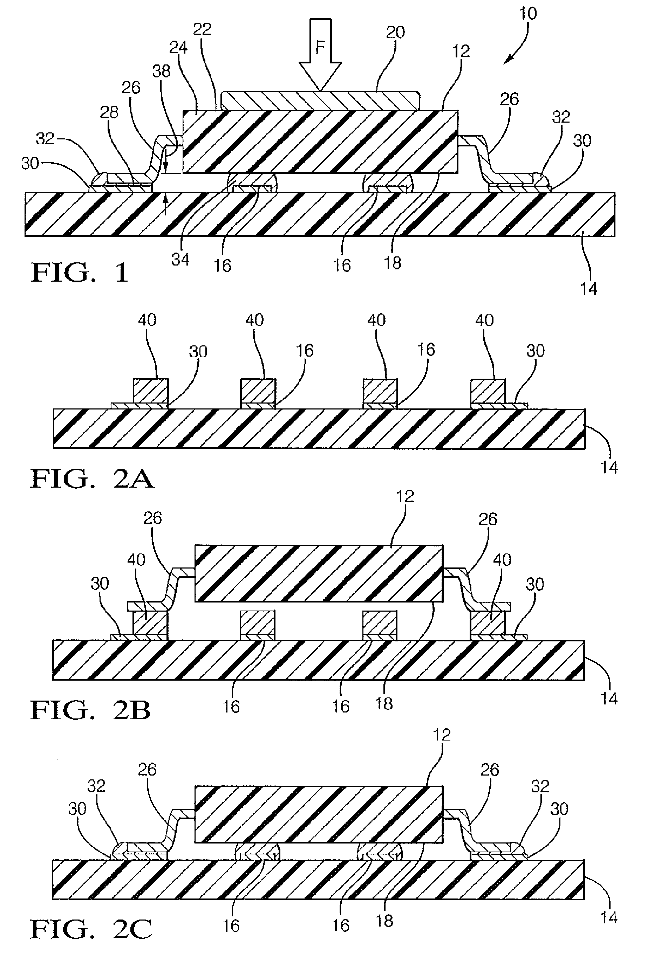

In accordance with an embodiment of a circuit board assembly, Fig. 1 illustrates a non-limiting example of a circuit board assembly system 10, hereafter often system 10, for supporting an electronic component 12 attached to a printed circuit board, hereafter often circuit board 14. As suggested in Fig. 1, the teachings herein are generally directed to leaded electronic components such as plastic packaged integrated circuits, but the teachings may also be applicable to other styles of electronic component packaging. The circuit board 14 may be formed of commonly known materials such as FR-4 or alumina.

The system 10 includes a solder pad 16 on the circuit board 14 that is generally aligned with a non-wetting region 18 of the electronic component 12. As used herein, a non-wetting region is a surface or feature of the electronic component 12 that solder will generally not wet or adhere to by, for example, forming inter-metallic alloys so the solder is securely bonded to the surface that the solder is wetting. For example, eutectic tin-lead solder will generally not wet surfaces formed of polymeric compounds. As will be explained in more detail below, the solder pad 16 is used in cooperation with solder to form a structure underneath the electronic component 12 so that solder joints used to attach the electronic component 12 to the circuit board 14 are not stressed or fatigued by a heat sink pressing on the electronic component 12 as described above in the Background.

As the solder pad 16 is not necessarily part of an electrical connection to the electronic component 12, the solder pad 16 may be electrically isolated from other features on the circuit board 14 that are part of an electric circuit. However, for purposes of absorbing radiated emissions emitted by the electronic component 12, or protecting the electronic component 12 from impinging electromagnetic energy or electrostatic discharge, it may be advantageous for the solder pad 16 to be electrically connected to an electric circuit, for example, to a ground plane within the circuit board 14.

Fig. 1 illustrates a non-limiting example of a heat sink 20 for dissipating heat generated by the electronic component 12. The heat sink 20 may be pressed against the electronic component 12 by a force F to improve thermal coupling between the electronic component 12 and the heat sink 20. The force F may be from a housing (not shown) or the like being clamped to or clamped around the circuit board 14 or system 10. The heat sink 20 may include other features not illustrated such as fins extending away from the electronic component 12. The heat sink 20 may also be thermally coupled to the housing by the application of the force F so that heat generated by the electronic component 12 passes through the heat sink 20 into the housing. Alternately, the heat sink 20 may be integral to the housing, either attached to or formed into the housing.

In one embodiment of the system 10, the electronic component 12 may include a body 22 formed of polymeric encapsulant 24 that defines the non-wetting region 18. Alternatively, the body 22 may be formed of ceramic and so define the non-wetting region 18, or the body 22 may be coated with a non-wetting material to define the non wetting region 18.

The electronic component 12 may also include a lead 26 extending from the body 22 for making electrical contact with the electronic component 12. The lead 26 is generally characterized as having solderable surface 28 and the circuit board 14 may include a contact pad 30 with solder that is aligned with the lead 26 for forming a solder joint 32 to attach the electronic component 12 to the circuit board 14.

t has been observed that during some durability testing, when a heat sink is pressed or forced against some leaded electronic components, such as the electronic component 12 illustrated, the solder joint 32 connecting the lead 26 extending to the contact pad 30 may exhibit signs if degradation earlier in the durability test than is the case when similar electronic components are not subjected to a heat sink being pressed or forced against the leaded electronic component. While not subscribing to any particular theory, the early onset of solder joint degradation is thought to be the result of the leads being flexed by the forced applied to the leaded electronic component. As such, it was suggested that if the leaded electronic component was supported in a manner effective to reduce or prevent flexing of the leads, durability test results could be improved.

To this end, the system 10 may also include a support 34 formed of solder overlying the solder pad 16 and proximate to the non-wetting region 18. As used herein, proximate to the non-wetting region 18 means that the support 34 is either contacting or in close enough contact to the non-wetting region 18 that flexing of the lead 26 by the force F is reduced when compared to the condition where the support 34 is absent. Durability testing of circuit board assemblies having supports similar to the support 34 illustrated have reduced the apparent onset of degradation of the solder joint 32.

It will be recognized that the size of the solder pad 16 and the amount of solder necessary to form the support 34 will need to be tailored to each particular electronic component design. When the solder is being reflowed, the force F is generally not present. As such, the size of the solder pad 16 and the amount of solder applied are coordinated so that during the reflow process the surface tension of the liquid solder that eventually forms the support 34 does not lift the electronic component 12 such that the lead 26 is separated from the contact pad 30. In particular, the size of the solder pad 16 and the amount of solder necessary to form the support 34 will be generally dependent on, but not limited to, the distance 38 between the non-wetting region 18 and the surface of the solder pad 16 or the surface of the circuit board 14, the weight of the electronic component 12, and the attracting force between the lead 26 and the contact pad 30 while the solder is in a liquid state.

Figs. 2A-C are a sequence of illustrations for describing the process of attaching the electronic component 12 to the circuit board 14 that includes forming the solder joint 32 and the support 34. Fig. 2A illustrates a circuit board 14 having a solder pad 16 and a contact pad 30 present on a surface of the circuit board 14. The solder pad 16 and contact pad 30 are normally formed using the same process, for example the known process photo-etching used to form printed circuit boards. Fig. 2A suggests that the contact pad 30 is larger than the solder pad 16, but this is only for the purposes of explanation, and not limitation. Fig. 2A also indicates that solder paste 40 has been applied to the solder pad 16 and the contact pad 30. The amount of solder paste 40 applied to each pad is generally controlled, for example by a screen printing process where by the amount of solder paste 40 applied is a function of a stencil thickness and a stencil aperture area for a stencil aperture aligned with the pad in question. Fig. 2A also suggests that the solder paste 40 on the solder pad 16 extends beyond the solder pad 16, while the solder paste 40 on the contact pad 30 does not extend beyond the contact pad 30. Again this is for the purpose of explanation and not limitation, and will become apparent following the explanation below.

Fig. 2B illustrates that the electronic component 12 has been placed on the circuit board 14 and that the lead 26 is partially within the solder past 40 on the contact pad 30. Fig. 2B suggests that there is a gap between the solder paste 40 on the solder pad 16 and the non-wetting region 18; however this is not a limitation. The electronic component 12 may be so lightly placed that the lead 26 would not appear to be partially within the solder paste 40. Alternatively, the electronic component 12 may be pressed down so that the solder paste 40 on the solder pad 16 does contact the non-wetting region 18, or the electronic component 12 may be configured so the lead 26 and the non-wetting area are co-planer, and so all of the solder paste 40 is contacting some portion of the electronic component 12.

Fig. 2B illustrates the circuit board assembly after the solder has been reflowed using any of several known methods and/or solder reflow time/temperature profiles. While not subscribing to any particular theory, when the solder paste 40 is heated above the melting temperature of the solder, the wetting action of the solder contacting the lead 26 and the contact pad 30 appears to pull the lead 26 toward the contact pad 30, and so the electronic component 12 may be drawn toward the circuit board 14. Contrariwise, the surface tension of liquid solder on the solder pad 16 appears to draw the liquid solder toward a spherical shape, and so may tend to force the electronic component 12 away from the circuit board 14. As such, it should be apparent that the size of the solder pad 16, the size of the contact pad 30, and the amount of solder paste 40 placed on each of these pads must be specifically tailored for each electronic component 12. When the solder paste 40 is sized to extend beyond the solder pad 16, sometimes called overprinting, as the solder paste 40 melts, the surface tension of the liquid solder appears to pull the solder that is beyond the solder pad 16 together to form a support 34. The amounts of solder paste 40 on each pad is selected to provide a solder joint 32 that securely attaches the electronic component 12 to the circuit board 14, and provide a support 34 that prevents the leads from being flexed by a force F (Fig. 1) applied to the electronic component 12.

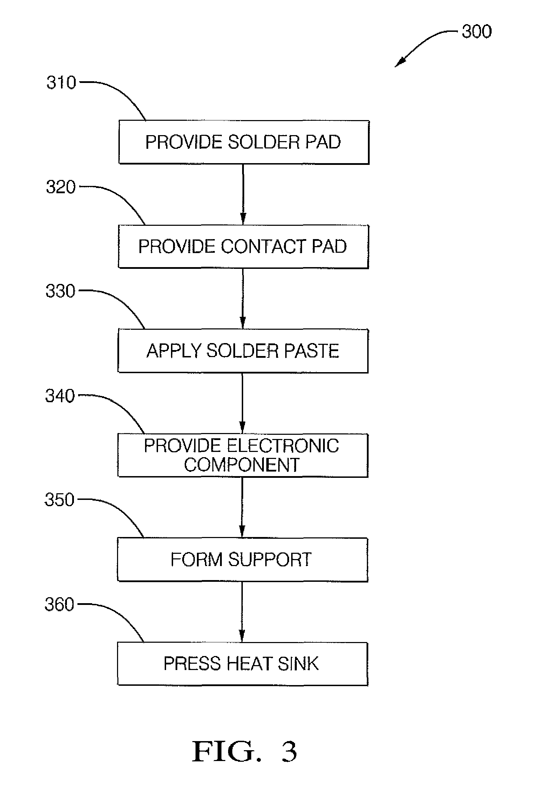

Fig. 3 illustrates a method 300 for supporting an electronic component 12 attached to a circuit board 14.

Step 310, PROVIDE SOLDER PAD, may include providing a solder pad 16 on the circuit board 14 aligned with a non-wetting region 18 of the electronic component 12. Step 310 may also include selecting a size of the solder pad 16 so that a subsequently formed support 34 will have suitable size characteristics.

Step 320, PROVIDE CONTACT PAD, may include providing a contact pad 30 on the circuit board 14 aligned with a lead 26 of the electronic component 12 that is configured to cooperate with the lead 26 to form a solder joint 32 to attach the electronic component 12 to the circuit board 14. Step 320 may also include selecting a size of the contact pad 30 so that a subsequently formed solder joint 32 will have suitable size characteristics.

Step 330, APPLY SOLDER PASTE, may include selecting a stencil thickness and aperture size for each pad, and screen printing solder paste 40 using the stencil to selectively apply solder paste 40 to the solder pad 16 and the contact pad 30.

Step 340, PROVIDE ELECTRONIC COMPONENT, may include providing an electronic component 12 comprising a body 22 formed of polymeric encapsulant that defines the non-wetting region 18, and a lead 26 extending from the body 22 for making electrical contact with the electronic component 12, and placing the electronic component 12 on the circuit board 14 so the lead 26 aligns with the contact pad 30 and the non-wetting region 18 aligns with the solder pad 16. Step 340 may also include placing the electronic component 12 onto the solder paste 40.

Step 350, FORM SUPPORT, may include subjecting the circuit board 14 and electronic component 12 to a suitable solder reflow temperature profile so as to heat the circuit board 14, electronic component 12, and solder paste 40 to a liquid state, and then cool the circuit board assembly to form the solder joint 32 and form the support 34 of solder overlying the solder pad 16 and proximate to the non-wetting region 18.

Step 360, PRESS HEAT SINK, may include placing the circuit board assembly (circuit board 14 with electronic component 12 attached) and the heat sink 20 into a housing (not shown) and closing the housing so the heat sink 20 is clamped or pressed against the electronic component 12 with a suitable force F (Fig. 1).

Accordingly, a system 10 and a method 300 of physically supporting an electronic component attached to a circuit board in order to prevent flexing of the lead 26 is provided. A structure or support 34 formed of solder is placed underneath an electronic component 12 so that when a heat sink 20 is forced or pressed against the electronic component 12, the solder joint 32 that electrically couples the electronic component to the circuit board 14 is not unduly stressed. The amount of solder for forming the support 34 and the solder joint 32, and the size of the solder pad 16 and the contact pad 30 are selected to optimize the strength of the solder joint 32 an bring the support into contacts with, or in close proximity to, the non-wetting region 18.

## Claims

1. A system (10) for supporting an electronic component (12) attached to a circuit board (14), said system (10) comprising:
a solder pad (16) on the circuit board (14);
a non-wetting region (18) of the electronic component (12) aligned with the solder pad (16); and
a support (34) formed of solder overlying the solder pad (16) and proximate to the non-wetting region (18).

2. The system (10) in accordance with claim 1, wherein the system (10) further comprises a heat sink (20) pressed against the electronic component (12) for dissipating heat generated by the electronic component (12).

3. The system (10) in accordance with claim 1, wherein the electronic component (12) comprises a body (22) formed of polymeric encapsulant (24) that defines the non-wetting region (18).

4. The system (10) in accordance with claim 3, wherein the electronic component (12) comprises a lead (26) extending from the body (22) for making electrical contact with the electronic component (12).

5. The system (10) in accordance with claim 4, wherein the lead (26) is characterized as having solderable surface (28) and the circuit board (14) comprises a contact pad (30) with solder that is aligned with the lead (26) for forming a solder joint (32) to attach the electrical component to the circuit board (14).

6. A method (300) of providing support (34) for an electronic component (12) attached to a circuit board (14), said method (300) comprising:
providing (310) a solder pad (16) on the circuit board (14);
aligned the solder pad (16) with a non-wetting region (18) of the electronic component (12); and
forming (350) a support (34) of solder overlying the solder pad (16) and proximate to the non-wetting region (18).

7. The method (300) in accordance with claim 6, wherein said method (300) further comprises the steps of
providing (340) an electronic component (12) comprising a body (22) formed of polymeric encapsulant (24) that defines the non-wetting region (18), and a lead (26) extending from the body (22) for making electrical contact with the electronic component (12); and
providing (320) a contact pad (30) configured to cooperate with the lead (26) to form a solder joint (32) to attach the electrical component to the circuit board (14).

8. The method (300) in accordance with claim 6, wherein the step of forming (350) a support (34) includes selectively applying (330) solder paste (40) to the solder pad (16), placing the electronic component (12) on the circuit board (14), and subjecting the circuit board (14) and electronic component (12) to a suitable solder reflow temperature profile.

9. The method (300) in accordance with claim 6, wherein said method (300) further comprises the step of pressing (360) a heat sink (20) against the electronic component (12).
